# EUROPEAN PATENT SPECIFICATION

(11) **EP 0 430 682 B1**
(45) Date of publication and mention of the grant of the patent: **06.09.1995**
(21) Application number: 90312968.2
(22) Date of filing: 29.11.1990
(51) Int. Cl.: G06F 11/20

(54) **Serial access semiconductor memory devices**
Halbleiterspeichergeräte mit Serienzugriff
Dispositifs de mémoire à semiconducteur à accès en série

(30) Priority: 30.11.1989 JP 311060/89
(43) Date of publication of application: 05.06.1991
(73) Proprietor: SONY CORPORATION, Tokyo 141 (JP)
(72) Inventor: Wakamatsu, Masataka, c/o Patents Division, Shinagawa-ku, Tokyo 141 (JP)
(74) Representative: Cotter, Ivan John

(56) References cited:
- EP-A- 0 172 016
- EP-A- 0 189 576
- EP-A- 0 243 859
- EP-A- 0 315 157
- EP-A- 0 315 257

## Description

This invention relates to serial access semiconductor memory devices.

A known semiconductor memory device usable as a video memory is arranged to perform serial inputting and outputting operations. Such a memory device usually has a serial access port of a word length equal to the number of memory cells of a row of the memory core or a fraction thereof.

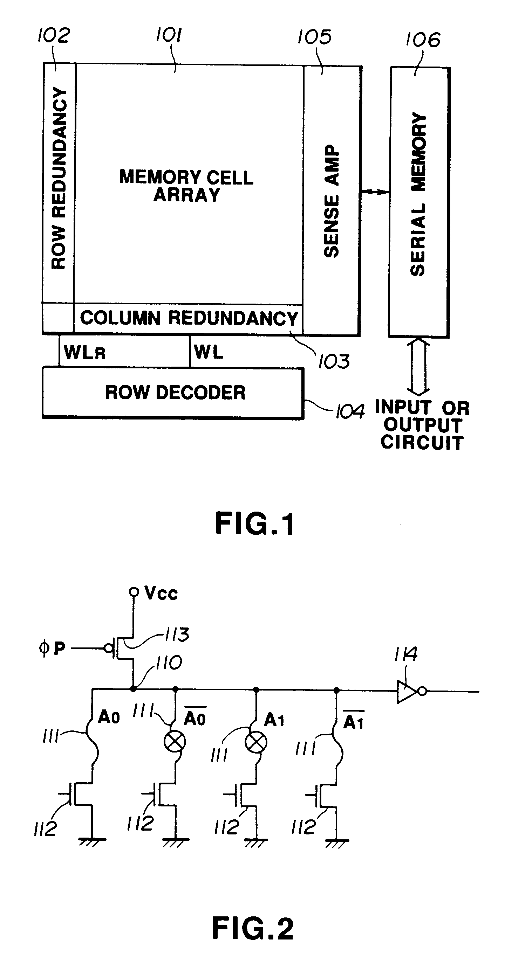

Figure 1 shows an example of the memory device having the usual serial memory. In one portion of a memory cell array 101 having memory cells arranged in a matrix configuration, a row redundant section 102 and a column redundant section 103 are provided for substitution of defective bits and improving the yield. The row redundant section 102 extends along the extending direction of the word line and is row-selected by a word line WL_{R} selected by a row decoder 104. On the other hand, the column redundant section 103 extends along the extending direction of the bit line. A word line WL is used for row selection of the column redundant section 103. Data are amplified by a sense amplifier 105 and inputted or outputted in parallel between the memory cell array 101 and a serial memory 106. The serial memory 106 has the function of transiently storing data and of serial-parallel or parallel-serial conversion, and is formed by a plurality of stages of flip-flops with selectors connected between. The serial memory 106 inputs or outputs data in series to or from the input-output circuit.

In a memory apparatus provided with such a serial memory 106, since data are inputted and outputted to or from the memory cell array 101 in parallel, a problem arises as to how data from the column redundant section 103 is to be exchanged. In connection with this problem, we have proposed in our Japanese patent application 1/247828 a technique of exchanging the defective bits and the redundant bits in the column redundant section. With this technique, a switching circuit is provided in a parallel data bus between the memory cell array and the serial memory, to perform switching between the column redundant section and the redundant bus.

In the technique of bus exchange, comparison between the defective address and the current address becomes necessary, and an address comparator circuit is used for this purpose. The address comparator circuit for generating the exchange signal is constructed as shown for example in Figure 2. A plurality of fuses 111 which can be melted by laser irradiation are connected in parallel with a node 110. A plurality of MOS transistors 112, to the gate of each of which a read-out address signal or its complementary address signal is supplied, are provided respectively between the earth line and the other ends of the fuses 111. Either the address side A₀, A₁ or the complementary side A̅₀, A̅₁ of the fuse 111 is melted bit-by-bit in accordance with the defective address. The node 110 is connected to a source voltage Vcc via a pMOS transistor 113, and is precharged to a source voltage Vcc when the pMOS transistor 113 is turned on by control signal φP. With this address comparator, the potential at the node 110 is maintained as it is, without being lowered, when the read-out address signal and its complementary address signal completely coincide with the melting pattern of the fuses 111. In the case of non-coincidence, the potential at the node 110 is lowered due to discharge via a fuse 111 and a MOS transistor 112, so that the output of an inverter 114 is raised. This signal is supplied as the switching signal between the redundant bus and the parallel data bus.

In general, in a mega-bit class DRAM, redundancy of about four columns is required, and it becomes necessary to switch between a plurality of redundant columns. In an image memory, the multi-bit construction is necessary, so that, when it is considered that the parallel-to-serial conversion section is distributed on the chip, it is not always effective to switch between the parallel data bus and the redundant bus.

That is, in a technique of switching between the parallel data bus and the redundant bus, switching signals are necessary for control, and an address comparison circuit making use of a fuse is required for generating the switching signal. When two or more redundant columns are switched on a bus-to-bus basis, it becomes necessary to provide a number of switching circuits equal to the number of redundant columns. Therefore, the scale of the changeover circuit is substantially increased, which complicates the generation of the switching signals. In the case of a multi-bit construction, it becomes necessary to provide the switching circuit for each parallel-to-serial converting section, which further increases the scale of the circuit.

When each serial memory of a video memory having a plurality of serial memories is to be operated asynchronously, the read-out or write address need to be compared with the defective address independently. In the case of utilizing the address comparator circuit shown in Figure 2, the fuse 111 and the MOS transistor 112 to which the addresses are entered, are inseparable. An address comparator circuit needs to be provided for each serial memory and the number of fuses is also increased with the number of the serial memories.

EP-A-0 243 859 discloses a semiconductor memory device having a matrix array of memory cells and a redundant storage matrix for storing data in lieu of defective memory cells of the array. The stages of a row buffer shift register receive parallel data from the array which is output serially via a multiplexer. Hold latches are connected to extensions of the bit lines associated with redundant columns of the redundant storage matrix, and the outputs of the hold latches are also connected to the multiplexer. A comparator compares the current read address with defective address data stored by fuse logic, and when a match is detected the comparator controls the multiplexer to select data from the appropriate hold latch rather than the row buffer register so that defective data is replaced by data from the redundant storage matrix.

According to the present invention there is provided a semiconductor memory device for reading out serial data stored therein, the device comprising:
a plurality of memory cells arranged in a two-dimensional matrix array of rows and columns;
column redundancy means for storing data in lieu of a defective memory cell of the array, being located adjacent to the array and having a number of rows of memory cells therein equal to that of the array;
controlling means comprising a fuse read only memory in which a defective address signal corresponding to the defective memory cell is stored, and a plurality of comparators for comparing the defective address signal from the fuse read only memory with respective read-out address signals generated asynchronously by a corresponding plurality of column counters to generate switching control signals;
selecting means for selecting one of the rows of the array and the column redundancy means simultaneously to output data from the array and the column redundancy means in parallel in response to a said readout address signal;
a plurality of parallel-serial converting means, associated with respective comparators and arranged to operate asynchronously, for inputting the data from the array and the column redundancy means and for outputting data in series, each parallel-serial converting means comprising a plurality of flip-flop circuits connected in series, in which the final flip-flop circuit outputs the data in series, and a plurality of selectors, comprising selectors respectively connected between successive flip-flop circuits in the series for selectively supplying data from the array or from the previous flip-flop circuit to the next flip-flop circuit in the series, wherein a said selector associated with the final flip-flop circuit is arranged to selectively output data from the column redundancy means, rather than data from the array or previous flip-flop circuit supplied thereto, in response to the switching control signal from the associated comparator.

Thus, in embodiments of the invention, a semiconductor memory device has an exclusive fuse ROM for controlling asynchronous comparators. In the case of employing memory blocks, the number of fuse ROMs corresponds to the number of memory blocks.

In an embodiment of the invention, each comparator comprises a plurality of sets of pairs of MOS transistors. The gate of each MOS transistor is supplied with the defective address signal, read-out address signal or the complementary signals.

In a particular embodiment of the invention, a fuse ROM comprises a fuse meltable according to the defective address and a MOS transistor controlled by a level which is the inverted level of the node between the fuse and the MOS transistor, for reducing stand-by current.

The invention will now be described by way of example with reference to the accompanying drawings, throughout which like parts are referred to by like references, and in which:
Figure 1 is a block diagram of a previously proposed memory device having a serial memory and a redundancy system;
Figure 2 is a circuit diagram of a previously proposed comparator;
Figure 3 is a block diagram for illustrating the operation of a memory device embodying the invention;
Figure 4 is a circuit diagram showing a serial-parallel conversion circuit of Figure 3;
Figure 5 is circuit diagram showing an example of a three-input selector;
Figure 6 is a view showing a switching table for the three-input selector;
Figure 7 is a timing chart for illustrating the usual read-out operation of the parallel-serial conversion circuit;
Figure 8 is a timing chart for illustrating the read-out operation at the time of redundant switching of the parallel-serial conversion circuit;
Figure 9 is a circuit diagram showing an example of a comparator employed in embodiments of the invention;
Figure 10 is a circuit diagram showing another example of a comparator circuit;
Figure 11 is a circuit diagram showing an example of a portion of the fuse ROM employed in the embodiments of the invention;
Figure 12 is a circuit diagram showing another example of the fuse ROM;
Figure 13 is a circuit diagram showing a modification of the example of Figure 11;
Figure 14 is a circuit diagram showing another modification of the example of Figure 11;
Figure 15 shows the connection of the comparators in the case of a three port embodiment; and
Figure 16 is a block circuit of an embodiment of three-port construction.

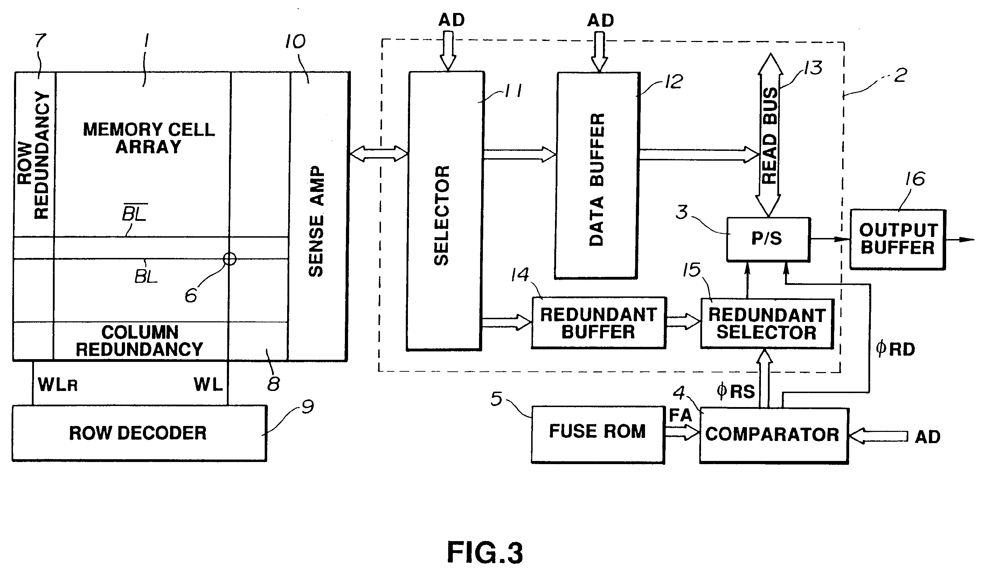

### Overall arrangement of a memory apparatus (Figure 3).

The memory device of Figure 3 is only a single port device but will be described first to assist understanding of the operation of embodiments of the invention. As shown in Figure 3, the memory device has a memory cell array 1 and a serial memory 2 capable of performing serial outputting. The memory cell array 1 is formed by memory cells 6 arrayed in a matrix configuration. Although not shown, each memory cell 6 is a 1-transistor-1-capacitor DRAM cell. A row redundant section 7 and a column redundant section 8 are provided at a portion of the terminal end of the memory cell array 1. The row redundant section 7 is a circuit section for substitution of a defective memory cell of the memory cell array 1 and is provided extending along the word line WL. The row of the defective memory cell is replaced by the row of the row redundant section 7. The column redundant section 8 is a circuit section for substitution of a defective memory cell of the memory cell array 1 as a row and is provided extending along the direction of extension of the bit lines BL and B̅L̅ which are substantially perpendicular to the word line WL. The row redundant section 7 is selected by a redundant word line WL_{R} using a row decoder 9. The column redundant section 8 is selected by a word line WL for selecting a usual memory cell 6 by a signal from the row decoder 9.

The memory cell array 1 is formed by, for example, a folded bit line structure and one of paired bit lines BL and B̅L̅ is used for reading or writing data of the memory cell 6 of one column, while the other is used for reference thereof. A sense amplifier 10 is provided at an end of the memory cell array 1 to amplify the potential difference between the bit line pair BL and B̅L̅. The paired bit lines BL and B̅L̅ and the sense amplifier 10 are also used for reading or writing data of the column redundant section 8.

The data which are amplified or are to be amplified by the sense amplifier 10 are transferred between it and a selector 11. The selector 11 has the function of read/write switching, that is the function of selecting the write data or the read-out data, and inputs and outputs data in parallel in either case. This selector 11 has the function of column selection and a part of data transferred in parallel is selected as a function of the address signal AD. The read-out data from the selector 11 are selected in accordance with the address signal AD. The read-out data from the selector 11 are transiently stored in a data buffer 12. The data from the column redundant section 8 are transferred via the selector 11 in parallel to a redundant buffer 14. The redundant data from the column redundant section 8 are not sent to the data buffer 12. The redundant data are transiently stored in the redundant buffer 14. Although the write data are not shown, data buffers or write busses are similarly used. A serial-parallel conversion circuit is employed between an input buffer circuit and a write bus. The column selecting function is not limited to that performed by both the selector 11 and the data buffer 12 and a construction comprising only one of them is allowable.

From the data buffer 12, data are read out sequentially in parallel to a 4-line bus 13 in accordance with the address signal AD. The read bus 13 is connected to a parallel-serial conversion circuit 3. As described subsequently, the parallel-serial conversion circuit 3 is formed by a plurality of series-connected flip-flop circuits. Switching between the defective data and the redundant data is performed in this parallel-serial conversion circuit 3. The data are converted in the parallel-serial conversion circuit 3 into serial data, and switching between the defective data and the redundant data is performed, after which data are transferred to an output buffer 16 so as to be output to the outside as a serial output signal D_{OUT}.

The channel for sending redundant data to the parallel-serial conversion circuit 3 is from the redundant buffer 14 via a redundant selector 15. The redundant data are transferred from the redundant selector 15 to the parallel-serial conversion circuit 3, with the transfer timing being controlled by a comparator circuit 4. Read-out address signals are entered into the comparator circuit 4 so as to be compared with the defective address signals FA from a fuse ROM 5. When the read-out address signal AD coincides with the defective address signal FA, a signal selecting redundant data is sent from the comparator circuit 4 to the redundant selector 15, and simultaneously a control signal φRD controlling the switching is transmitted from the comparator circuit 4 to the parallel-serial conversion circuit 3. The fuse ROM 5 is a circuit for causing the defective address signal FA of the memory cell array 1 to be stored in the fuse melting pattern. A specific example of the comparator circuit 4 and the fuse ROM will be explained subsequently.

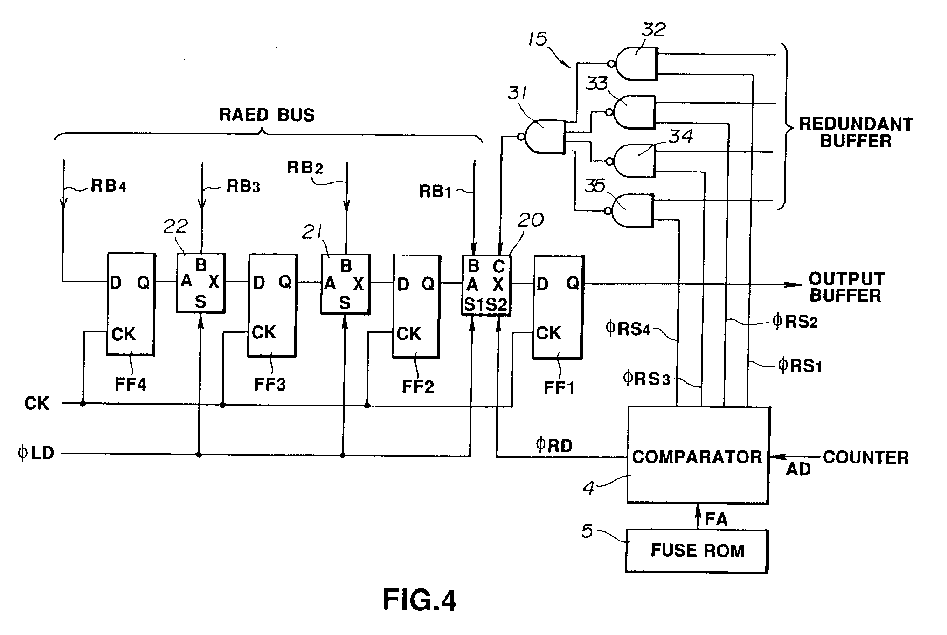

### Structural Example of Parallel-Serial Conversion Circuit (Figures 4 to 6)

Referring to Figure 4, a specific circuit arrangement mainly of the parallel-to-serial conversion circuit 3 will now be explained.

The parallel-serial conversion circuit 3 comprises four serially connected flip-flop circuits FF1 to FF4, as shown in Figure 4. The flip-flops FF1 to FF4 are D flip-flops having an input terminal as the D terminal and the output terminal as the Q terminal. Each of the flip-flops FF1 to FF4 is fed with clock signals CK from a clock generator, not shown. Each flip-flop FF1 to FF4 has selectors 20, 21 and 22 connected between its Q terminal and the D terminal of the next flip-flop. The selectors 20 to 22 select whether or not the flip-flops FF1 to FF3 should fetch data from the read bus 13. Of these, the selector 20 provided at the input of the flip-flop FF1 of the final stage switches between data from the flip-flop FF2, data from the read bus 13, or redundant data from the redundant selector 15, in order to enable switching with redundant data, to cause the selected data to be supplied to the D terminal of the flip-flop FF1.

In more detail, a fourth line RB₄ of the read bus 13 is connected to the D terminal of the initial stage flip-flop FF4.

The terminal Q of this terminal stage flip-flop FF4 is connected to a terminal A of the selector 22. The terminal B of the selector 22 is connected to the third line RB₃ of the read bus 13. A signal controlling the selection is supplied to a terminal S of the selector 22. When the signal φLD is at "H" level, data from the read bus 13, that are data at the terminal B, appears at a terminal X, that is an output terminal of the selector 22.

Conversely, when the signal φLD is at "L" level, data from the flip-flop FF4, that is data from the terminal A, appears at the terminal X, that is an output terminal of the selector 22. The terminal X of the selector 22 is connected to the terminal D of the next flip-flop FF3.

The terminal Q of the flip-flop FF3 is connected to the terminal A of the selector 21. The terminal B of the selector 21 is connected to the second line RB₂ of the read bus 13. The selector 21 functions similarly to the selector 22 and switches inputs to the terminals A and B by the signal φLD to supply the selected input to the terminal X. The terminal X of the selector 21 is connected to the terminal D of the flip-flop FF2.

The terminal Q of the flip-flop FF2 is connected to the terminal A of the selector 20. The terminal B of the selector 20 is connected to the first line RB₁ of the read bus 13. The selector 20 has, in addition to the terminals A and B, a terminal C, to which redundant data from the redundancy selector 15 as later described is supplied. For switching the selector 20, signals are supplied to terminals S1 and S2. The signal φLD is supplied to the terminal S1, similarly to the other selectors 21 and 22. The signal φRD for switching to redundant data is supplied to the terminal S2.

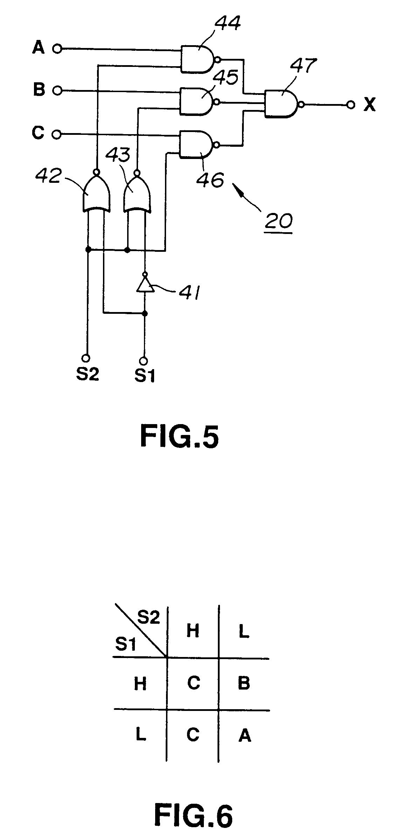

Figure 5 shows a more specific circuit of the selector 20. The terminal S1 acts not only as an input terminal to an inverter 41 but also as an input terminal to a NOR circuit 42. A signal φLD is supplied to the terminal S1. The output terminal of the inverter 41 is connected to one input terminal of a NOR circuit 43. The terminal S2 acts as a common input terminal to the NOR circuits 42 and 43 and a NAND circuit 46. The output terminal of the NOR circuit 42 is connected to one input terminal of a NAND circuit 44, the other input terminal of which is the terminal A. The output terminal of the NOR circuit 43 is connected to one input terminal of a NAND circuit 45. The other input terminal of the NAND circuit 45 is the terminal B. The NAND circuit 46, which has the terminal S2 as one input terminal, has a terminal C as the other input terminal. The output terminals of the NAND circuits 44, 45 and 46 are the input terminals of a NAND circuit 47, the output terminal of which is the terminal X.

The selector 20, having the above circuit construction, operates in accordance with the Table shown in Figure 6.

First, when the signal φRD supplied to the terminal S2, is at the "L" level, the terminal connected to the terminal X is switched between the terminals A and B, depending on the level of the signal φLD supplied to the terminal S1.

That is, when the terminal S2 is at the "L" level and the terminal S1 is at the "H" level, the output of the NOR circuit 43 is at the "H" level, so that the NAND circuit 44 is inactive, whereas the NAND circuit 45 is active. The NAND circuit 46, directly connected to the terminal S2, is inactive. Thus the terminal B is connected to the terminal X via the NAND circuit 45 and 47.

When the terminal S2 is at "L" level and the terminal S1 is also at "L" level, the output of the NOR circuit 43 is at "L" level, so that the NAND circuit 44 is active, and the NAND circuit 45 is inactive. The NAND circuit 46, directly connected to the terminal S2, is also inactive. Thus the terminal A is connected to the terminal X via the NAND circuits 44 and 47.

When the terminal S2 is at "H" level, the outputs of the NOR circuits 42 and 43 are at "L" level, irrespective of the inputs at the S1 terminal. Both the NAND circuits 44 and 45 are inactive and data of the terminals A and B are interrupted. Only the NAND circuit 46 is active and the terminal C is connected to the terminal X via the NAND circuits 46 and 47.

In this manner, the 3-input selector 20 is controlled by the signal φLD and φRD supplied to the terminals S1 and S2 to effect switching between data from the read bus 13, data which are transmitted serially, and redundant data.

When the data supplied to the flip-flop FF1 of the final stage are to be the redundant data, it suffices to set the signal φRD supplied to the terminal S2 to "H" level. This signal φRD is formed in the comparator circuit 4 and is formed on the basis of the results of comparison of the defective address signal FA and the read-out address signal AD.

The comparator circuit 4 generates the selection signals φRS₁ to φRS₄ for the redundant selector 15 simultaneously with the signal φRD. Referring to the circuit construction of the redundant selector 15, it is so arranged that four redundant fuses form the redundant buffer 14 in association with 4-column redundancy, with each line of the redundant bus being connected to one input terminal of each of the NAND circuit 32 to 35. To the other input terminal of the NAND circuit 32 is supplied a signal φRS₁ from the comparator circuit 4 and to the other input terminal of the NAND circuit 34 is supplied a signal φRS₃ from the comparator circuit 4. To the other input terminal of the NAND circuit 35 is supplied a signal φRS₄ from the comparator circuit 4. These signals φRS₁ to φRS₄ go to "H" level on the basis of the results of comparison at the comparator circuit 4 and only a redundancy bus line associated with the NAND circuit supplied with the "H" level signal φRS is connected to the terminal C of the selector 20 via the NAND circuit 31. Simultaneously, the signal φRD goes "H" and the signal appearing at the terminal X of the selector 20 is the redundant data at the terminal C to effect switching between the defective data and the redundant data.

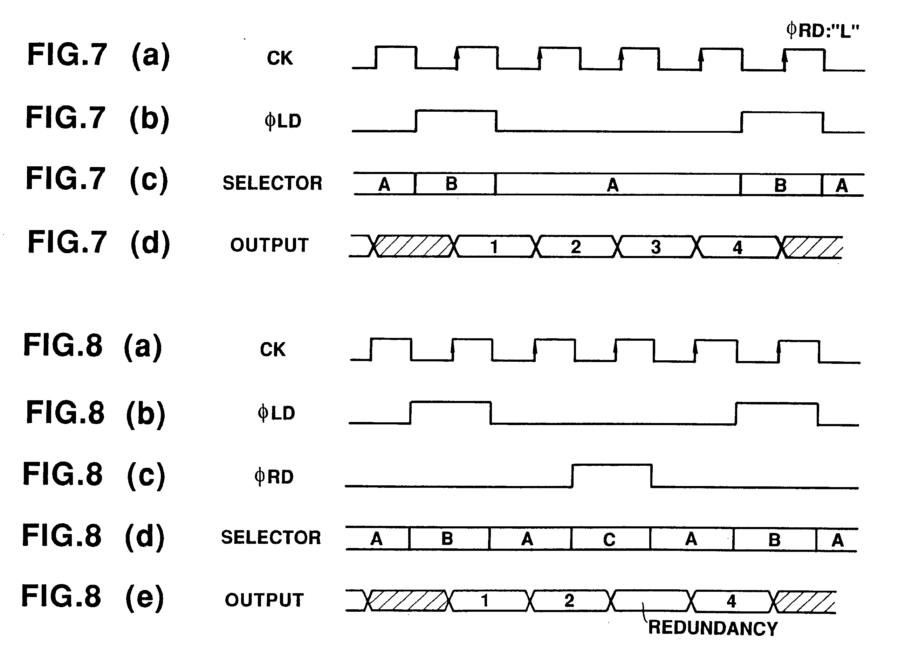

### Usual Read-Out Operation (Figure 7)

Now referring to Figure 7, the usual read-out operation, that is the operation for the case in which redundant data substitution is not performed, is explained.

Figure 7(a) shows a clock signal CK supplied to each of the flip-flops FF1 to FF4. Data supplied to D-terminals of the flip-flop FF1 to FF4 at the rising time of the clock signal CK appear at the Q-terminals.

Figure 7(b) shows a signal φLD for fetching the signal on the read bus via the selector 20. This signal φLD goes periodically to "H" level during one clock among four clocks of the clock signal CK.

Now turning to the operation of the parallel-serial converter circuit 3, the signal φLD goes "H" and, during this time, the terminal X of the selectors 20 to 22 are electrically connected to the terminal B, as shown in Figure 7(c). That is, data on the fourth line RB₄ of the read bus 13 are supplied to the terminal D of the flip-flop FF4, data on the third line RB₃ of the read bus 13 are supplied to the terminal D of the flip-flop FF3 via the selector 22, data on the second line RB₂ of the read bus 13 are supplied to the terminal D of the flip-flop FF2 via the selector 21 and data on the first line RB₁ of the read bus 13 are supplied to the terminal D of the flip-flop FF1 via the selector 20. With the rise of the clock signal CK during the time the signal φLD is at the "H" level, each of the data is outputted at the Q-terminal of each of the flip-flop FF1 to FF4 and, the output of Figure 7(d), data on the first line RB₁ shown at "1" is transferred to an output buffer.

The signal φLD is changed from "H" level to "L" level and each of the selectors 20 to 22 is controlled for connecting the terminal A to the terminal X. During the rise of the next clock signal CK, data on the second line RB₂ appear at the Q-terminal of the flip-flop circuit FF1 of the final stage. Figure 7(d) shows the output as "2". Simultaneously, the output of the flip-flop FF2 are the data on the third line RB₃, while the output of the flip-flop FF3 are sequentially the data on the fourth line RB₄. Data are again shifted sequentially during the rise of the clock signal CK and the output turns out to be the data on the third and fourth lines RB₃ and RB₄. In Figure 7(d), data on the third line RB₃ are indicated at "3" while data on the fourth line RB₄ are indicated at "4".

After passage through four periods of the clock signal CK, the signal φLD again rises from "L" level to "H" level, such that the data on the first to fourth lines RB₁ to RB₄ of the read bus 13 are loaded into the parallel-serial converter 3. Parallel-to-serial conversion is performed in a similar manner, to transfer serial read-out data to an output buffer.

### Read-out Operation during Redundancy Switching (Figure 8)

Referring to Figure 8, an explanation will now be given for the case in which data on the third line RB₃ of the read bus 13 are the defective data and switching is to be made to the redundant data.

Similarly to the case of Figure 7, the signal φLD goes to the "H" level, as shown in Figure 8(b), for the range which covers one half period before and after rising of the clock signal CK shown in Figure 8(a). Then, as shown in Figure 8(d), the inputs from the B terminals of the selectors 20 to 22 of the parallel-to-serial converter 3 appear at the terminals X, while data from the read bus 13 appear at the terminals X of the selectors 20 to 22. These data are transferred to the Q terminals of the flip-flop FF1 to FF4 with the rise of the clock signal CK during the time the signal φLD is at the "H" level. The output signal shown in Figure 8(e) turns out to be the data on the first line RB₁ as shown at "1" in the drawing.

After the signal φLD goes to "L" level, data on the second line RB₂ are output at the final stage flip-flop FF1 with the rise of the next clock signal CK. At this stage, the defective data on third line RB₃ are transferred to the output of the flip-flop FF2 preceding the final stage while the defective data on the third line RB₃ are transferred to the D-terminal of the final stage flip-flop FF1. For switching the defective data, the signal φRD from the comparator 4 goes "H" as shown in Figure 8(c). That is, the defective address signal FA corresponding to the defective data is stored in the fuse ROM 5 and is compared at the comparator circuit 4 with the address signal AD from a counter. The signal φRD goes "H" in case of coincidence. Simultaneously, the comparator circuit 4 causes the control signals φRS₁ to φRS₄ of the redundant selector 15 to go alternately "H" to activate one of the NAND circuits 32 to 35 selectively to output redundant data from the NAND circuit 31.

When the signal φRD is at "H" level, the terminal C of the selector 20 is connected to the terminal X no matter what kind of signal is supplied to the terminal S1. Hence, the redundant data from the NAND circuit 31 is transferred to the D terminal of the final stage flip-flop FF1 via the terminals C and X of the selector 20. This results in substitution of the redundant data for the previously transferred defective data. As a result, the substituted redundant data appear at the Q terminal of the final stage flip-flop FF1 at the rising of the clock signal CK after the signal φRD goes to "H". This is shown as "redundancy" in Figure 8(e). Then, similarly to the case of Figure 7, data are transferred to the next flip-flop at the rising of the clock signal CK and read-out from the read bus 13 to parallel-to-serial converter circuit 3 is performed when the signal φLD goes to "H" for an interval of four clock periods.

With the above described circuit arrangement of the parallel-to-serial converter circuit 3, two to four bit defective data on the same read bus 13 may be substituted without in any way increasing the circuit size. Thus it suffices to load the redundant data from the redundant selector 15 under control from the comparator circuit 4 which raises the signal φRD to "H" level whenever the defective data to be substituted pass through the selector 20. When for example the first line RB₁ and the third line RB₃ on the read bus 13 are simultaneously carrying defective data, the signal φRD is simultaneously raised to "H" level at a clock which raises the signal φLD to "H" level and control is subsequently performed to raise the signal φRD to the "H" level after two clocks. Substitution of the redundant data for defective data may be performed by controlling the signals φRS₁ to φRS₄ simultaneously and loading the redundant data of the redundant bus from the NAND circuit 31.

### Modification of the Parallel-Serial Converter Circuit

The parallel-serial converter circuit 3 shown in Figure 4 includes a plurality of series-connected flip-flops FF1 to FF4 and a selector 20 at an input to the final stage flip-flop circuit FF1 to effect switching between the defective data and the redundant data.

Switching between the redundant data and the defective data is not limited to the input of the final stage flip-flop FF1, but may be made at the output side of the final stage flip-flop FF1. That is, the selector 20 is not of the 3-input type, but may be similar to the selectors 21 and 22, and a new selector is provided at the Q terminal of the flip-flop FF1. It suffices if the signal φRd is supplied to the terminal S of the selector and the redundant data from the NAND circuit 31 are supplied to the terminal B, with the terminal A being connected to the Q terminal, and the terminal X being connected to an output buffer. Such a circuit arrangement sufficiently allows defective data to be substituted for redundant data to read out redundant data without increasing the circuit size, even in case of substitution of two or more bits.

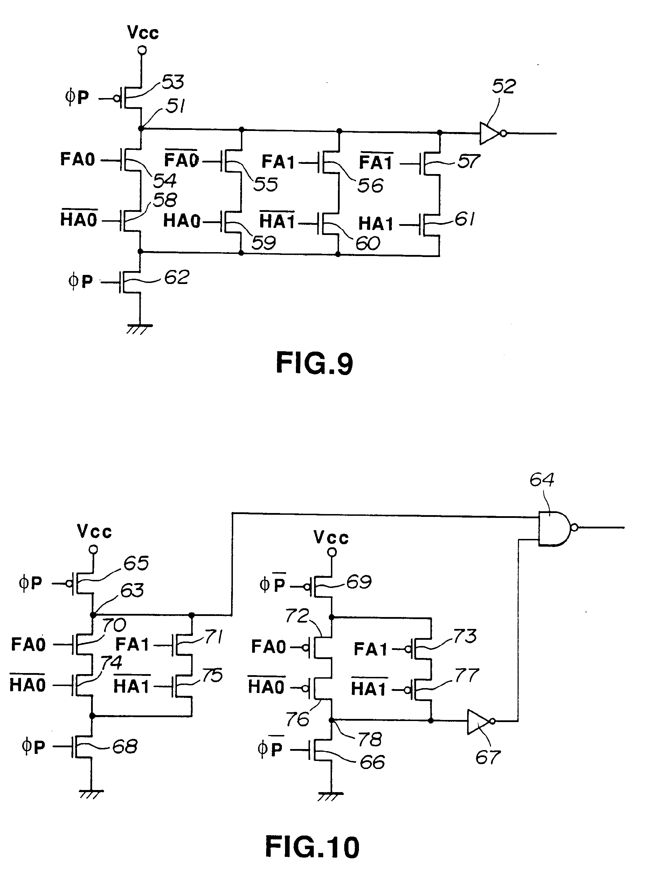

### Example of the Comparator Circuit (Figure 9)

As described above, the comparator circuit 4 is used for comparing the defective address signal FA with read-out address signals or the like compared address signals.

Figure 9 shows an example of the comparator circuit 4. Turning to the construction, a precharging pMOS transistor 53 is provided between a node 51 detecting the potential and a source voltage Vcc and is controlled by the signal φP. A parallel connection of sets of paired MOS transistors connected in cascade are provided so as to be connected to the node 51. nMOS transistor 54-nMOS transistor 58, nMOS transistor 55-nMOS transistor 59, nMOS transistor 56-nMOS transistor 60 and nMOS transistor 57-nMOS transistor 61 are connected in tandem as sets. With this comparator circuit, four sets of paired MOS transistors are provided for comparing 2-bit address signals. For comparing more bits of address signal, the number of sets of MOS transistors may be increased to 6, 8, ..., and may in effect by a multiple of the number of bits of the column address signals. The sources of the nMOS transistors 58 to 61 are connected in common, and supplied with the earth voltage GND via an nMOS transistor 62. A precharging signal φP is supplied to the gate of this nMOS transistor 62 similarly to pMOS transistor 53. The node 51 is to be the input terminal of an inverter 52, and the output of the inverter 52 is used for switching from defective data to redundant data as the above signal φRD as a signal indicating the results of comparison of the comparator circuit 4.

Turning to the signal supplied to the gate of each MOS transistor, a first bit address signal FA0 of the defective address signal is supplied to the gate of the nMOS transistor 54. The first-bit complementary address signal H̅A̅0̅ of the compared address signal is supplied to the nMOS transistor 58. To the gate of the nMOS transistor 55 is supplied a first bit complementary address signal F̅A̅0̅ of the defective address signal. To the gate of the nMOS transistor 59 is supplied the first bit complementary address signal HA0 of the compared address signal. To the gate of nMOS transistor 56 is supplied the second bit address signal FA1 of the defective address signal. To the gate of the nMOS transistor 60 is supplied the second bit complementary address signal H̅A̅1̅ of the compared address signal. To the gate of the nMOS transistor 57 is supplied the second bit complementary address signal F̅A̅1̅ of the defective address signal. To the gate of the nMOS transistor 61 is supplied the second bit address signal HA1 of the compared address signal.

The operation of this comparison circuit 4 will now be described. The defective address signals FA0, F̅A̅0̅, FA1 and F̅A̅1̅ are supplied from the fuse ROM 5 having various constructions as will be explained subsequently. The compared address signals HA0, H̅A̅0̅, HA1 and H̅A̅1̅ are generated in the column counter and are supplied to the comparator circuit 4.

In the comparison operation, assuming that the defective address signal is, for example, "01", the bits F̅A̅0̅ and FA1 of the bits of the defective address signal go "H" while the bits FA0 and F̅A̅1̅ are at "L" level. The compared address signals HA are changed sequentially with the operation of the column counter. It is assumed that, with the above pattern of the defective address, the compared address signal HA is "01". In this case, bits H̅A̅0̅ and HA1 of the compared address signal go to "H" while bits HA0 and H̅A̅1̅ go to "L".

Then, one MOS transistor of the set of cascade connected MOS transistors is turned on, and the potential of the node 51 precharged by the signal φP to the source potential Vcc is maintained as it is, without the potential at the node 51 being discharged. Hence, in this case only, the output level of the inverter 52 goes to "L". With the result of comparison of the "L" level, it is shown that the defective address signal FA coincides with the compared address signal HA.

In other cases wherein, for example, the compared address signal is "00" or "01", there is a combination wherein both of the cascade-connected MOS transistor sets are turned on, with the level at the node 51 being lowered. Thus the state of non-coincidence is indicated by the "H" level of the output of the inverter 52.

The above construction of the comparator circuit 4 has no portion that is melted by a fuse and is simply so designed as to compare the signal from the fuse ROM with the compared address signal. Therefore, to increase the number of ports, the defective address signal from the common fuse ROM is used commonly, so that it is possible to prevent overlapping of the melting operation or increase of the circuit size.

Also, as shown in Figure 9, the MOS transistors supplied with defective address signals and complementary address signals thereof are arrayed on the side of the cascade-connected nodes 51, so that the charging and discharging regions with respect to the nodes 51 are not enlarged even when the compared address signal progresses. That is, since the defective address signals and the complementary address signals thereof are fixed data, they are not changed as are the compared address signals. For this reason, by arraying the MOS transistors fixedly actuated by these data at the sides of the nodes 51, the region contributing to changes in potential of the node 51 may be reduced to provide for fast read-out and prevent a mistaken operation.

### Another Example of the Comparator Circuit (Figure 10)

Referring to Figure 10, another example of a comparator circuit 4 for comparing the defective address signal FA and the compared signal such as the read-out address signal will be explained.

This comparator circuit has an nMOS transistor 70 and an nMOS transistor 74 connected in cascade, and also has an nMOS transistor 75 connected in cascade with respect to the node 63. The node 63 is connected via a pMOS transistor 65 to a source voltage Vcc. A signal φP is supplied to the gate of the pMOS transistor 65, and the node 63 is precharged when the signal φP goes to "1" level. The sources of the nMOS transistors 74 and 75 are connected to earth voltage GND via a nMOS transistor 68. The signal φP is similarly supplied to the gate of this nMOS transistor 68.

The pMOS transistor 72 and the pMOS transistor 76 are connected in cascade in a set, while the pMOS transistor 73 and the pMOS transistor 77 are connected in cascade in a set, with respect to the node 78. To this node 78 are connected pMOS transistors 76 and 77. The earth voltage GND is supplied to this node 78 by means of an nMOS transistor 66. The signal φP is supplied to the gate of the nMOS transistor 66. When the signal φP is at "H" level, the node 78 is precharged to the earth voltage GND by means of the nMOS transistor 66. The signal φP is an inversion of the signal φP. The sources of the pMOS transistors 72 and 73 are connected to the drain of the pMOS transistor 69. The source of this pMOS transistor 69 is connected to the source voltage Vcc. The signal φP is supplied to the gate of the pMOS transistor 69.

The node 63 is the node at which the potential is detected and is one input of an NAND gate 64. The node 78 is also the node at which the potential is detected and is used as the other input of the NAND gate 64 by means of an inverter 67. The output of the NAND gate 64 is the signal indicating the result of comparison of the comparator circuit 4.

The first bit address signal FA0 of the defective address signal is supplied to the gate of the nMOS transistor 70. To the gate of the nMOS transistor 74 is supplied the first-bit complementary address signal H̅A̅0̅ of the compared address signal. To the gate of the nMOS transistor 71 is supplied the second bit address signal FA1 of the defective address signal. To the gate of the nMOS transistor 75 is supplied the second bit complementary address signal H̅A̅1̅ of the compared address signal. To the gate of the pMOS transistor 72 is supplied the first bit address signal FA0 of the defective address signal. To the gate of the pMOS transistor 76 is supplied the first bit complementary address signal H̅A̅0̅ of the compared address signal. To the gate of the pMOS transistor 73 is supplied the second-bit address signal FA1 of the defective address signal. To the gate of the pMOS transistor 77 is supplied the second bit complementary address signal H̅A̅1̅ of the compared address signal.

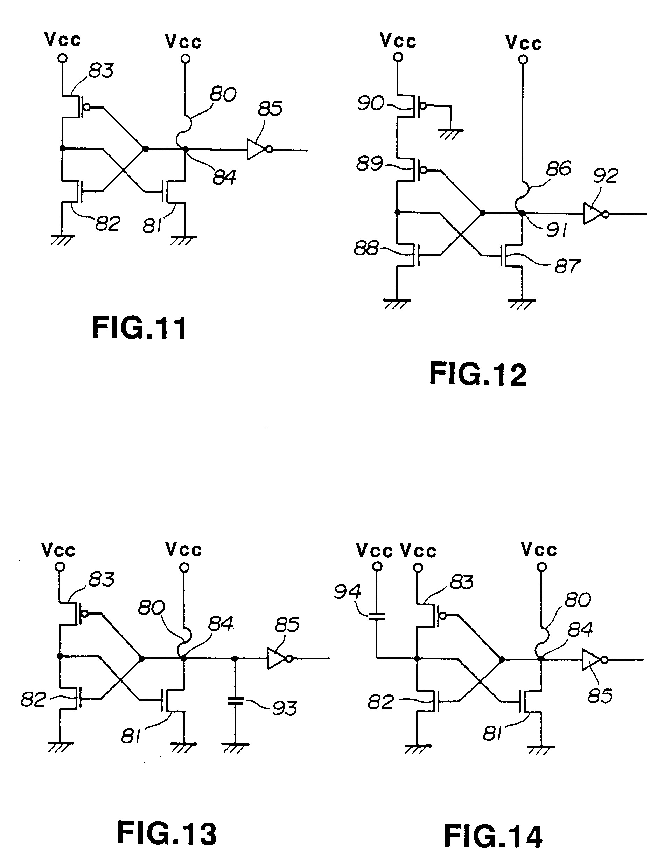

With the above described comparator circuit 4, similarly to the comparator of Figure 9, when the defective address signal coincides fully with the compared address signal, the current path is interrupted in any sets of the cascade-convected MOS transistor sets, so that no charging and discharging occurs at the nodes 63 and 78, and the pre-charge potential is maintained. Hence, the two inputs of the NAND circuit 64 are both at "H" level, so that the output thereof is at "L" level, thus indicating that the addresses coincide as in the circuit of Figure 9. If the defective address signal FA is not coincident with the compared address signal HA, the potentials at the nodes 63 and 78 are changed, so that the output of the NAND circuit 64 is at "H" level. Portion of Fuse ROM (Figure 11)

Figure 11 shows an example of a circuit forming a fuse ROM. In this memory device, a fuse that melts to store the defective address signal is provided outside the comparator circuit.

The 1-bit construction of the fuse ROM is shown in Figure 11. A fuse 80 and an nMOS transistor 81 are arranged in series between the source voltage Vcc and the earth voltage GND. The source of the nMOS transistor 81 is connected to the earth voltage GND, and the source voltage Vcc is supplied to one end of the fuse 80. The output, that is the 1-bit signal of the defective address signal is taken out at a junction 84 between the fuse 80 and the nMOS transistor 81 by means of an inverter 85.

The junction 84 is connected to the gate of an nMOS transistor 82 and to a gate of a pMOS transistor 83 to form an inverter. The source of the pMOS transistor 83 is supplied with the source voltage Vcc, while the source of the nMOS transistor 82 is supplied with the earth voltage GND. The drains of the MOS transistors 82 and 83, the outputs of the inverter, are connected to the gate of the nMOS transistor 81.

The resistance of the fuse 80 is selected to be smaller than the ON-resistance of the pMOS transistor 83. As an example, the ON-resistance of the pMOS transistor 83 is several tens of kilohms, whereas the ON-resistance of the fuse 80 is several hundreds of ohms.

The circuit operation as follows. If the fuse 80 is not melted, the junction 84 towards the fuse 80 is at "H" level when the power is turned on. The "H" level speed is higher than at the inverter side, so that the pMOS transistor 83 tends to be turned off, while the nMOS transistor 82 tends to be turned on, so that the nMOS transistor 81 is turned off and latched. Ultimately, the nMOS transistor 81 and the pMOS transistors 83 are turned off to suppress the through-current to reduce the stand-by current nearly to zero. The nMOS transistor 81 is turned off and the potential at the junction 84 is at "H" level and the output at the inverter 85 is at "L" level.

When the fuse 80 then melts, the potential at the junction 84 remains at "L" level when the power is turned on and the drain potential of the pMOS transistor 82 and the nMOS transistor 81 at the inverter side is at "H" level. As a result, the nMOS transistor 81 is turned on and the potential at the junction 84 is latched at the earth voltage GND so that the nMOS transistor 82 is turned off. With the nMOS transistor 82 thus turned off, the stand-by current is reduced to zero.

With the above described fuse ROM circuit, the current path between the source voltage Vcc and the voltage GND is interrupted by the latching of the MOS transistors 81, 82 and 83, no matter whether the fuse 80 is melted or not, so that the stand-by current may be reduced.

### Portion of Fuse ROM (Figure 12)

Figure 12 shows another example of a circuit forming a fuse ROM, and a modification of the circuit of Figure 11.

As shown in Figure 12, showing this circuit, a fuse 86 and an nMOS transistor 87 are connected in series between the source voltage Vcc and the earth voltage GND. The source of the nMOS transistor 87 is the earth voltage GND and the source voltage Vcc is supplied to one end of the fuse 86. The output, that is the 1-bit signal of the defective address signal, is taken out at a junction 91 between the fuse 86 and the nMOS transistor 87 via an inverter 92.

The junction 91 is also connected to the gate of the nMOS transistor 88 and the gate of the pMOS transistor 89 forming an inverter. The source of the pMOS transistor 89 is connected to the drain of the pMOS transistor 90, functioning as the load resistor, and the source voltage Vcc is supplied to the source of this pMOS transistor 90. The earth voltage GND is applied to the gate of this pMOS transistor 90. The source of the pMOS transistor 88 is at the earth voltage GND. The drains of the MOS transistors 89 and 88, which are the outputs of this inverter, are connected to the gate of the nMOS transistor 87.

In the above circuit construction, comparison with the circuit of Figure 11 reveals that the pMOS transistor 90 has been provided at the source side of the pMOS transistor 89. By such addition of the pMOS transistor 90 having its gate at the earth voltage GND, the junction 91 can be positively brought to "H" level when the power is turned on when the fuse is not melted. That is, when the power is turned on, the voltage at the source of the pMOS transistor 90 is maintained at 0 V until the source voltage Vcc exceeds the threshold voltage Cth of the pMOS transistor, so that the potential at the junction 81 is positively raised.

Similarly to the circuit of Figure 11, the stand-by current can be reduced sufficiently by latching no matter whether or not the fuse 86 is melted.

### Portion of the fuse ROM (Figure 13)

Figure 13 shows a further example of a circuit forming the fuse ROM, and comprises a capacitor 93 added to the circuit of Figure 11. The construction similar to that of Figure 11 is represented by using the same reference numerals, and the corresponding description is omitted for simplicity.

A capacitor 93 is provided between the junction 84 and the earth voltage line. By providing the capacitor 93 in this manner, the potential at the junction 84 may be positively set to the "L" level by capacitive connection with the earth voltage GND on melting of the fuse 80. The stand-by current can naturally be lowered as in the circuit of Figure 11.

### Portion of Fuse ROM (Figure 14)

Figure 14 shows a further example of the circuit forming the fuse ROM and comprises a capacitor added to the circuit of Figure 11. The construction similar to that of Figure 11 is represented by the same reference numerals and the corresponding description is omitted.

A capacitor 94 is provided between the power voltage line and the junction between the inverter side pMOS transistor 83 and the nMOS transistor 82. By providing the capacitor 94 in this manner, the inverter output level may be raised towards the source voltage Vcc, so that the potential at the junction 84 may be brought positively to the "L" level.

The stand-by current can naturally be reduced similarly to the circuit of Figure 11.

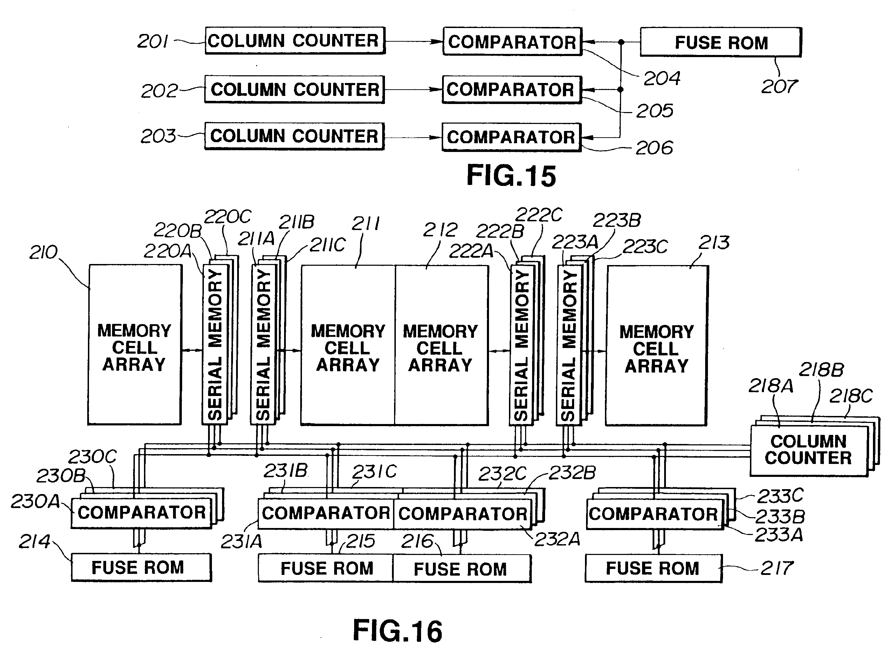

### Construction of Multiport Memory Device (Figures 15 and 16)

With the memory device described above, the comparator circuit for comparing the compared address signals such as the write or read addresses and the defective address signals is separate from the fuse ROM storing the defective address signal. When the memory device includes a plurality of serial memories, a common fuse ROM is used.

Figure 15 shows the construction of a comparator circuit in which three ports, that is three serial memories are controlled asynchronously.

With this construction, the three serial memories are controlled independently, so that three column counter circuits 201, 202 and 203 are provided separately and each supplies address signals for column selection of the memory cell array as required. Three comparators 204, 205 and 206 are provided in association with the serial memories and are supplied with compared signals from the column counter circuit 201, 202 and 203. Only one fuse ROM 207, having the above-mentioned fuse, and supplying defective address signals stored by the melting pattern, is provided in correspondence with the number of the memory cell array without correspondence to the number of serial memories. That is, since the defective address signal is determined in association with the memory cell array, it is supplied to the comparators 204, 205 and 206 from the exclusive fuse ROM 207 in the form of electrical signals, so that switching between the defective data and the redundance data in the three separate serial memories may be made with only one fuse ROM.

Figure 16 shows the overall construction of the memory device divided into blocks. In the present example, the memory cell array is divided into four portions, with the fuse ROMS 214, 215, 216 and 217 corresponding to the memory cell arrays 210, 211, 212 and 213, respectively. Three serial memories are provided for each of the memory cell arrays 210, 211, 212 and 213, divided into the blocks. Serial memories 220A, 220B and 220C are provided for the memory cell array 210, serial memories 221A, 221B and 221C are provided for the memory cell array 211, serial memories 222A and 222B and 222C are provided for the memory cell array 212, and serial memories 223A, 223B and 223C are provided for the memory cell array 213. These serial memories 220A, 220B, 220C to 223A, 223B and 223C are respectively provided with comparators 230A, 230B, 230C to 233A, 233B and 233C, and switching between the defective data and the redundant data is performed by, for example, the signals φRD from the comparators 230A, 230B, 230C to 233A, 233B and 233C.

From a column counter circuit 218A, of the three column counter circuits, address signals are transmitted to the serial memories 220A, 221A, 222A and 223A, respectively; from a column counter circuit 218B, address signals are transmitted to the serial memories 220B, 221B, 222B and 223B, respectively; and from a column counter circuit 218C, address signals are transmitted to the serial memories 220C, 221C, 222C and 223C, respectively.

With the above described memory device, if we direct attention to the routes of the defective and compared address signals supplied to the comparators 230A, 230B, 230C to 233A, 233B and 233C, the comparators 230A, 231A, 232A and 233A are supplied with the compared signals from the column counter circuit 218A, the comparators 230B, 231B, 232B and 233B are supplied with the compared address signals from the column counter circuit 218B, and the comparator circuits 230C, 231C, 232C and 233C are supplied with the compared address signals from the column counter circuit 218C. However, the defective address signal is supplied from the fuse ROM 214 to the comparators 230A, 230B and 230C, the defective address signals are supplied from the fuse ROM 215 to the comparators 231A, 231B and 231C, the defective address signals are supplied from the fuse ROM 216 to the comparators 232A, 232B and 232C, and the defective address signals are supplied to the fuse ROM 217 from the comparators 233A, 233B and 233C.

In this manner, even if the separate memory cell arrays 210 to 213 are each provided with separate three serial memories 220A, 220B, 220C to 223A, 223B and 223C, the fuse ROM needs to be provided only in a number corresponding to the memory cell array. Hence, even with the above described multi-port construction, the overlapped melt fusing operation may be eliminated and switching between the defective data and the redundance data may be achieved positively with the memory device provided with serial memories.

## Claims

1. A semiconductor memory device for reading out serial data stored therein, the device comprising:
a plurality of memory cells (6) arranged in a two-dimensional matrix array (1) of rows and columns;
column redundancy means (8) for storing data in lieu of a defective memory cell (6) of the array (1), being located adjacent to the array (1) and having a number of rows of memory cells (6) therein equal to that of the array (1);
controlling means comprising a fuse read only memory (207) in which a defective address signal corresponding to the defective memory cell (6) is stored, and a plurality of comparators (204 to 206) for comparing the defective address signal from the fuse read only memory (207) with respective read-out address signals generated asynchronously by a corresponding plurality of column counters (201 to 203) to generate switching control signals;
selecting means (11) for selecting one of the rows of the array (1) and the column redundancy means (8) simultaneously to output data from the array (1) and the column redundancy means (8) in parallel in response to a said read-out address signal;
a plurality of parallel-serial converting means (3), associated with respective comparators (204 to 206) and arranged to operate asynchronously, for inputting the data from the array (1) and the column redundancy means (8) and for outputting data in series, each parallel-serial converting means (3) comprising a plurality of flip-flop circuits (FF1 to FF4) connected in series, in which the final flip-flop circuit (FF1) outputs the data in series, and a plurality of selectors, comprising selectors (20 to 22) respectively connected between successive flip-flop circuits (FF1 to FF4) in the series for selectively supplying data from the array (1) or from the previous flip-flop circuit to the next flip-flop circuit in the series, wherein a said selector (20) associated with the final flip-flop circuit (FF1) is arranged to selectively output data from the column redundancy means (8), rather than data from the array (1) or previous flip-flop circuit (FF1, FF2) supplied thereto, in response to the switching control signal from the associated comparator (204 to 206).

2. A device according to claim 1 wherein the column redundancy means (8) has a plurality of columns of memory cells (6), the device including redundant data buffer means (14) for storing parallel data from the column redundancy means (8), and redundant selector means (15) for selecting data from the parallel data in the redundant data buffer means (14) in accordance with the switching control signal from a said comparator (204 to 206) and outputting the selected data to the selector (20) associated with the final stage (FF1) of the parallel-serial conversion means associated with that comparator.

3. A device according to claim 1 or claim 2 wherein the array (1) of memory cells (6) is divided into a plurality of memory blocks, respective said column redundancy means (8), controlling means, selecting means (11) and parallel-serial converting means (3) being associated with each memory block, whereby the number of fuse read only memories (207) corresponds to the number of memory blocks.

4. A device according to any preceding claim wherein each comparator (204 to 206) comprises a plurality of sets of pairs of MOS transistors (54 to 61), the sets being connected in parallel between a first potential and second potential, one MOS transistor of a pair being controlled by the defective address signal or a complementary defective address signal, the other MOS transistor of a pair being controlled by the read-out address signal or a complementary read-out address signal, the number of sets being equal to twice the number of bits of the address signals.

5. A device according to claim 4 wherein the switching control signal generated by a said comparator (204 to 206) is generated by the level at a node (51) of the first potential, the MOS transistors which are controlled by the defective address signal or the complementary defective address signal being provided at the first potential side, and wherein the node (51) is precharged after each generation of the switching control signal.

6. A device according to any preceding claim wherein the or each fuse read only memory (207) comprises a fuse (80) melted according to the address of a defective memory cell (6), and a MOS transistor (81) connected in series with the fuse (80) between a first potential and a second potential, the gate of the MOS transistor (81) being supplied with a level which is the inverted level of the node (84) between the fuse (80) and the MOS transistor (81).

7. A device according to claim 6 wherein the level supplied to the gate of the MOS transistor (81) is produced by an inverter having a complementary MOS transistor structure.

## Patentansprüche

1. Halbleiterspeichereinrichtung zum Auslesen serieller Daten, die darin gespeichert sind, wobei die Einrichtung aufweist:
- mehrere Speicherzellen (6), die in einer zweidimensionalen Matrix-Anordnung (1) aus Zeilen und Spalten angeordnet sind,
- eine Spalten-Redundanzeinrichtung (8), die zu der Anordnung (1) benachbart angeordnet ist und eine Anzahl von Zeilen der Speicherzellen (6) darin aufweist, die der der Anordnung (1) gleich ist, um anstelle in einer defekten Speicherzelle (6) der Anordnung (1) Daten zu speichern,
- eine Steuereinrichtung, die einen Sicherheits-Nur-Lesespeicher (207), in dem ein Defekt-Adressensignal gespeichert ist, das der defekten Speicherzelle (6) entspricht und mehrerer Komparatoren (204-206) aufweist, um das Defekt-Adressensignal aus dem Sicherheits-Nur-Lesespeicher (207) mit jeweiligen Auslese-Adressensignalen zu vergleichen, die mit entsprechend vielen Spaltenzählern (201-203) asynchron erzeugt wurden, um Umschalt-Steuersignale zu erzeugen,
- Wähleinrichtungen (11), um eine der Zeilen der Anordnung (1) und die Spalten-Redundanzeinrichtung (8) gleichzeitig auszuwählen, um auf das Auslese-Adressensignal hin Daten aus der Anordnung (1) der Spalten-Redundanzeinrichtung (8) parallel auszugeben,
- mehrere Parallel/Seriell-Wandler (3), die jeweiligen Komparatoren (204-206) zugeordnet und zum asynchronen Betrieb angeordnet sind, um die Daten aus der Anordnung (1) und der Spalten-Redundanzeinrichtung (8) einzugeben und um Daten seriell auszugeben, wobei jeder Parallel/Seriell-Wandler (3) mehrere Flip-Flop-Schaltungen (FF1-FF4) aufweist, die in Serie verbunden sind, und deren letzte Flip-Flop-Schaltung (FF1) die Daten seriell ausgibt und mehrere Selektoren aufweist, die mit Selektoren (20-22) jeweils zwischen aufeinanderfolgenden Flip-Flop-Schaltungen (FF1-FF4) in der Reihe verbunden sind, um Daten aus der Anordnung (1) oder von der vorhergehenden Flip-Flop-Schaltung der nächsten Flip-Flop-Schaltung in der Reihe selektiv zuzuführen, wobei ein Selektor (20), der der letzten Flip-Flop-Schaltung (FF1) zugeordnet ist, angeordnet ist, um auf das Umschalt-Steuersignal von dem zugeordneten Komparator (204-206) in Daten von der Spalten-Redundanzeinrichtung (8) anstelle von Daten aus der Anordnung (1) oder der vorhergehenden Flip-Flop-Schaltung (FF1, FF2) die diesem zugeführt sind, selektiv auszugeben.

2. Einrichtung nach Anspruch 1, bei der die Spalten-Redundanzeinrichtung (8) mehrere Spalten aus Speicherzellen (6) aufweist, wobei die Einrichtung eine redundante Daten-Zwischenspeichereinrichtung (14), um parallele Daten aus der Spalten-Redundanzeinrichtung (8) zu speichern, und eine redundante Selektoreinrichtung (15) aufweist, um Daten aus den parallelen Daten in der redundanten Daten-Zwischenspeichereinrichtung (14) gemäß des Umschalt-Steuersignals von einem der Komparatoren (204-206) auszuwählen, und um die ausgewählten Daten an den Selektor (20) auszugeben, der der letzten Stufe (FF1) der dem Komparator zugeordneten Parallel/Seriell-Wandler zugeordnet ist.

3. Einrichtung nach Anspruch 1 oder 2, bei dem die Anordnung (1) der Speicherzellen (6) in mehrere Speicherblöcke aufgeteilt ist, wobei die Spalten-Redundanzeinrichtung (8), die Steuereinrichtung, die Wähleinrichtung (11) und die Parallel/Seriell-Wandler (3) jeweils ihrem Speicherblock zugeordnet sind, wobei die Anzahl der Sicherheits-Nur-Lesespeicher (207) der Anzahl der Speicherblöcke entspricht.

4. Einrichtung nach einem der vorhergehenden Ansprüche, wobei jeder Komparator (204-206) mehrere Sätze von MOS-Transistorpaaren (54-61) aufweist, wobei die Sätze parallel zwischen einem ersten und einem zweiten Potential verbunden sind, wobei ein MOS-Transistor eines Paares von einem Defekt-Adressensignal oder einem komplementären Defekt-Adressensignal gesteuert wird, der andere MOS-Transistor des Paares von dem Auslese-Adressensignal oder einem komplementären Auslese-Adressensignal gesteuert wird, wobei die Anzahl der Sätze gleich der doppelten Anzahl der Adressensignalbits ist.

5. Einrichtung nach Anspruch 4, bei der das von einem Komparator (204-206) erzeugte Umschalt-Steuersignal bei einem Pegel an einem Knoten (51) des ersten Potentials erzeugt wird, wobei die MOS-Transistoren, die von dem Defekt-Adressensignal oder dem komplementären Defekt-Adressensignal gesteuert werden, auf der Seite des ersten Potentials vorgesehen sind, und wobei der Knoten (51) nach jedem Erzeugen des Umschalt-Steuersignals vorgeladen wird.

6. Einrichtung nach einem der vorhergehenden Ansprüche, bei der der oder jeder Sicherheits-Nur-Lesespeicher (207) eine Sicherung (80), die gemäß der Adresse der defekten Speicherzelle (6) durchgeschmolzen ist, und einen MOS-Transistor (81) aufweist, der in Serie mit der Sicherung (80) zwischen einem ersten Potential und einem zweiten Potential verbunden ist, wobei dem Gate des MOS-Transistors (81) ein erster Pegel zugeführt wird, der der invertierte Pegel des Knotens (84) zwischen der Sicherung (80) und dem MOS-Transistor (81) ist.

7. Einrichtung nach Anspruch 6, bei dem der dem Gate des MOS-Transistors (81) zugeführte Pegel von einem Inverter erzeugt wird, der eine komplementäre MOS-Transistor-Struktur aufweist.

## Revendications

1. Dispositif de mémoire à semiconducteurs pour lire des données série mémorisées à l'intérieur, dispositif comportant :
une pluralité de cellules de mémoire (6) disposées selon un réseau matriciel bidimensionnel (1) de lignes et de colonnes;
des moyens de redondance de colonne (8) pour mémoriser des données à la place d'une cellule de mémoire défectueuse (6) du réseau (1), situés adjacents au réseau (1) et possédant un nombre de lignes de cellules de mémoire (6) égal à celui du réseau (1);
des moyens de commande comportant une mémoire morte à fusible (207) dans laquelle un signal d'adresse défectueuse correspondant à la cellule de mémoire défectueuse (6) est mémorisé, et une pluralité de comparateurs (204 à 206) pour comparer le signal d'adresse défectueuse provenant de la mémoire morte à fusible (207) à des signaux d'adresse de lecture respectifs générés de façon asynchrone par une pluralité correspondante de compteurs de colonne (201 à 203) pour générer des signaux de commande de commutation;
des moyens de sélection (11) pour sélectionner l'une des lignes du réseau (1) et les moyens de redondance de colonne (8) simultanément pour délivrer des données provenant du réseau (1) et les moyens de redondance de colonne (8) en parallèle en réponse audit signal d'adresse lu;
une pluralité de moyens de conversion parallèle-série (3) associés à des comparateurs respectifs (204 à 206) et agencés pour fonctionner de façon asynchrone, pour entrer les données provenant du réseau (1) et des moyens de redondance de colonne (8) et pour délivrer des données en série, chaque moyen de conversion parallèle-série (3) comportant une pluralité de circuits bascules (FF1 à FF4) montés en série, dans lesquels le circuit bascule final (FF1) délivre les données en série, et une pluralité de sélecteurs comportant des sélecteurs (20 à 22) respectivement montés entre les circuits bascules successifs (FF1 à FF4) en série pour délivrer sélectivement des données provenant du réseau (1) ou du circuit bascule précédent au circuit bascule suivant de la série, dans lesquels un desdits sélecteurs (20) associé au circuit bascule final (FF1) est agencé pour délivrer sélectivement des données provenant des moyens de redondance de colonne (8), plutôt que des données provenant du réseau (1) ou du circuit bascule antérieur (FF1, FF2) appliquées à celui-ci, en réponse au signal de commande de commutation provenant du comparateur associé (204 à 206).

2. Dispositif selon la revendication 1, dans lequel les moyens de redondance de colonne (8) possèdent une pluralité de colonnes de cellules de mémoire (6), le dispositif comprenant des moyens de mémoire-tampon de données redondants (14) pour mémoriser des données parallèles provenant des moyens de redondance de colonne (8), et des moyens de sélection redondants (15) pour sélectionner des données provenant des données parallèles dans les moyens de mémoire-tampon de données redondants (14) conformément au signal de commande de commutation provenant d'un comparateur (204 à 206) et délivrer les données sélectionnées au sélecteur (20) associé à l'étage final (FF1) des moyens de conversion parallèle-série associés à ce comparateur.

3. Dispositif selon la revendication 1 ou la revendication 2, dans lequel le réseau (1) de cellules de mémoire (6) est divisé en une pluralité de blocs de mémoire, lesdits moyens de redondance de colonne respectifs (8), les moyens de commande, les moyens de sélection (11) et les moyens de conversion parallèle-série (3) étant associés à chaque bloc de mémoire, de telle sorte que le nombre de mémoires mortes à fusible (207) correspond au nombre de blocs de mémoire.

4. Dispositif selon l'une quelconque des revendications précédentes, dans lequel chaque comparateur (204 à 206) comporte une pluralité d'ensembles de paires de transistors MOS (54 à 61), les ensembles étant reliés en parallèle entre un premier potentiel et un second potentiel, un transistor MOS d'une paire étant commandé par le signal d'adresse défectueuse ou un signal d'adresse défectueuse complémentaire, l'autre transistor MOS d'une paire étant commandé par le signal d'adresse de lecture ou un signal d'adresse de lecture complémentaire, le nombre d'ensembles étant égal à deux fois le nombre de bits des signaux d'adresse.

5. Dispositif selon la revendication 4, dans lequel le signal de commande de commutation généré par un comparateur (204 à 206) est généré par le niveau sur un noeud (51) du premier potentiel, les transistors MOS qui sont commandés par le signal d'adresse défectueuse ou le signal d'adresse défectueuse complémentaire étant appliqués du côté du premier potentiel, et dans lequel le noeud (51) est préchargé après chaque génération du signal de commande de commutation.

6. Dispositif selon l'une quelconque des revendications précédentes, dans lequel la ou chaque mémoire morte à fusible (207) comprend un fusible (20) fondu selon l'adresse d'une cellule de mémoire défectueuse (6), et un transistor MOS (81) monté en série avec le fusible (80) entre un premier potentiel et un second potentiel, la grille du transistor MOS (81) recevant un niveau qui est le niveau inversé du noeud (84) entre le fusible (80) et le transistor MOS (81).

7. Dispositif selon la revendication 6, dans lequel le niveau délivré à la grille du transistor MOS (81) est produit par un inverseur ayant une structure de transistor MOS complémentaire.
